Europäisches Patentamt

European Patent Office

Office européen des brevets

(11) Veröffentlichungsnummer: **0 306 930**
**A2**

## (12) EUROPÄISCHE PATENTANMELDUNG

(21) Anmeldenummer: 88114633.6

(22) Anmeldetag: 07.09.88

(51) Int. Cl.⁴: **H05K 1/02 , H05K 3/34**

(30) Priorität: 10.09.87 DE 3730455

(43) Veröffentlichungstag der Anmeldung:
15.03.89 Patentblatt 89/11

(84) Benannte Vertragsstaaten:
**DE FR GB**

(71) Anmelder: **Siemens Aktiengesellschaft Berlin
und München
Wittelsbacherplatz 2
D-8000 München 2(DE)**

(72) Erfinder: **Böing, Bernd
Kiefernweg 5
D-4290 Bocholt(DE)**
Erfinder: **Veurman, Johannes
Kaiser-Wilhelm-Strasse 56
D-4290 Bocholt(DE)**

(54) **Auf einer Leiterplatte angeordnete Leiterbahnen mit Anschlusspunkten für ein eine Vielzahl von Anschlüssen aufweisendes elektronisches Bauelement.**

(57) Auf einer Leiterplatte angeordnete Leiterbahnen (2) mit Anschlußpunkten (3, 4) für ein elektronisches Bauelement sollen so auf der Leiterplatte (1) angeordnet werden, daß die Verbindung von Bauelement und Leiterplatte (1) in einem Fertigungsautomaten erfolgen kann.

Die Verbindung von Bauelement und Leiterplatte (1) erfolgt durch Schwallöten, wobei die Anschlußpunkte (3, 4) zur Durchlaufrichtung der Leiterplatte (1) im Lötbad unter einem Winkel von 45° angeordnet sind und jeweils in den Eckbereichen der rechteckig zueinander angeordneten Anschlußpunkte (3, 4) Abzugsflächen (5, 6, 7, 8) vorgesehen sind, die größere Abmessungen aufweisen, als die einzelnen Anschlußpunkte (3, 4).

EP 0 306 930 A2

**Auf einer Leiterplatte angeordnete Leiterbahnen mit Anschlußpunkten für ein eine Vielzahl von Anschlüssen aufweisendes elektronisches Bauelement.**

Die vorliegende Erfindung beinhaltet auf einer Leiterplatte angeordnete Leiterbahnen mit Anschlußpunkten für ein eine Vielzahl von Anschlüssen aufweisendes elektronisches Bauelement, z. B. Mikroprozessor, wobei die vorverzinnten Anschlußpunkte rechteckförmig zueinander angeordnet sind.

Bisher wurde ein eine Vielzahl von Anschlüssen aufweisendes elektronisches Bauelement zunächst lagerichtig zu den bereits vorverzinnten Anschlußpunkten positioniert, wobei anschließend die einzelnen Anschlußpunkte durch Erwärmen mit den Anschlüssen des Bauelementes verbunden wurden. Dieses Erwärmen erfolgte bisher durch eine beheizte Zange, die den einzelnen Anschlußpunkten das Lötzinn zuführte. Ein derartiges Verfahren weist jedoch den großen Nachteil auf, daß die Befestigung des Bauelementes auf der Leiterplatte einen relativ hohen Aufwand an Zeit und Kosten erforderte. Versuche, das Bauelement im Schwallötverfahren auf der Leiterplatte zu befestigen, scheiterten zunächst daran, daß sich immer wieder zwischen den eng benachbarten Anschlußpunkten Lötbrücken bildeten, die mit großem Zeitaufwand von Hand wieder entfernt werden mußten.

Der vorliegenden Erfindung liegt daher die Aufgabe zugrunde, die Anschlußpunkte so auf der Leiterplatte anzuordnen, daß die Verbindung von Bauelement und Leiterplatte in einem Automaten erfolgen kann.

Diese Aufgabe wird dadurch gelöst, daß die Anschlüsse des lagerichtig zu den Anschlußpunkten positionierten Bauelementes im Schwallötverfahren mit den Anschlußpunkten der Leiterplatte elektrisch und mechanisch verbunden werden, wobei die Anschluß punkte zur Durchlaufrichtung der Leiterplatte im Lötbad unter einem Winkel von 45° angeordnet sind, und jeweils in den Eckbereichen der Anschlußpunkte Abzugsflächen vorgesehen sind, die größere Abmessungen aufweisen als die einzelnen Anschlußpunkte. Dadurch, daß die Anschlußpunkte unter einem Winkel von 45° zu der Durchlaufrichtung der Leiterplatte im Lötbad verlaufen, bilden sich Lötbrücken nur noch in den Eckbereichen der rechteckförmig zueinander angeordneten Anschlußpunkte. Um von den in diesen Eckbereichen befindlichen Anschlußpunkten das die Brükken verursachende Lötzinn abzuhalten, sind in den Eckbereichen die größere Abmessungen als die Anschlußpunkte aufweisenden Abzugsflächen vorgesehen. Aufgrund der größeren Abmessungen der Abzugsflächen besitzen diese eine größere Oberflächenspannung und ziehen somit das überschüssige Lötzinn von den in diesem Bereich befindlichen Anschlußpunkten ab.

Beim Schwallöten ist üblicherweise die größte Lötzinnzufuhr im mittleren Bereich des Lötbades. Dadurch weisen die in Durchlaufrichtung der Leiterplatte liegenden Abzugsflächen eine größere Oberfläche auf, als die senkrecht zur Durchlaufrichtung angeordneten Abzugsflächen. Dabei werden die Abzugsflächen vorzugsweise dreieckförmig gestaltet.

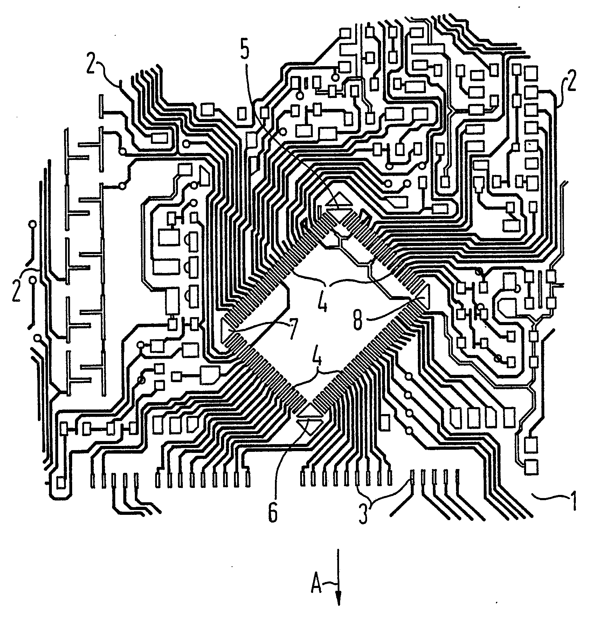

Die Erfindung soll im folgenden anhand eines Ausführungsbeispiels näher erläutert werden. In der Abbildung ist eine Leiterplatte ausschnittsweise wiedergegeben.

Auf der Leiterplatte sind eine Vielzahl von Leiterbahnen 2 sowie Anschlußpunkte 3 und 4 für elektrische sowie elektronische Bauteile angeordnet. Im vorliegenden Anwendungsfall soll ein viele Anschlüsse aufweisendes und zu den vorverzinnten Anschlußpunkten lagerichtig positioniertes elektronisches Bauelement, z. B. ein rechteckförmig gestalteter Mikroprozessor im Schwallötverfahren mit der Leiterplatte 1 elektrisch und mechanisch verbunden werden. Die Durchlaufrichtung der Leiterplatte durch das Lötbad ist mit dem Richtungspfeil A angegeben. Zu diesem Zweck sind die ebenfalls rechteckförmig zueinander ange ordneten Anschlußpunkte vorzugsweise unter einem Winkel von 45° zur Durchlaufrichtung angeordnet. Da sich beim Schwallöten überwiegend in den Eckbereichen Brücken zwischen den dicht benachbarten (Millimeterbereich) Anschlußpunkten bildeten, sind zur Vermeidung solcher unerwünschter Brückenbildungen Abzugsflächen 5, 6, 7 und 8 vorgesehen, die überflüssiges Lötzinn aufnehmen. Diese Abzugsflächen 5, 6, 7 und 8 sind wesentlich größer als die verzinnten Anschlußpunkte 4 für den Mikroprozessor und weisen in diesem Falle eine dreieckförmige Ausbildung auf. Da beim Schwallöten die größte Lötzinnzufuhr im mittleren Bereich des Lötbades erfolgt, sind die Abzugsflächen 5 und 6 vergrößert ausgebildet, d. h. sie können mehr Lötzinn abziehen, als die Abzugsflächen 7 und 8.

**Ansprüche**

1. Auf einer Leiterplatte (1) angeordnete Leiterbahn (2) mit Anschlußpunkten für ein eine Vielzahl von Anschlüssen aufweisendes elektronisches Bauelement, z. B. Mikroprozessor, wobei die vorverzinnten Anschlußpunkte rechteckförmig zueinander angeordnet sind, **dadurch gekennzeichnet,** daß die Anschlüsse des lagerichtig zu den Anschlußpunkten (3, 4) positionierten Bauelementes im Schwallötverfahren mit den Anschlußpunkten der Leiterplatte (1) elektrisch und mechanisch verbunden wird, wobei die Anschlußpunkte (3, 4) zur Durchlaufrichtung der Leiterplatte (1) im Lötbad unter einem Winkel von 45° angeordnet sind und jeweils in den Eckbereichen der Anschlußpunkte (3, 4) Abzugsflächen (5, 6, 7, 8) vorgesehen sind, die größere Abmessungen aufweisen, als die einzelnen Anschlußpunkte (3, 4).

2. Leiterplatte nach Anspruch 1, **dadurch gekennzeichnet,** daß die Abzugsflächen (5, 6, 7, 8) dreieckförmig gestaltet sind.

3. Leiterplatte nach Anspruch 1 und 2, **dadurch gekennzeichnet,** daß die sich in Durchlaufrichtung der Leiterplatte (1) gegenüberliegenden Abzugsflächen (5, 6) größer ausgebildet sind, als die senkrecht zur Durchlaufrichtung angeordneten Abzugsflächen (7, 8).